# EUROPEAN PATENT SPECIFICATION

(11) **EP 0 435 644 B1**
(45) Date of publication and mention of the grant of the patent: **20.03.1996**
(21) Application number: 90314231.3
(22) Date of filing: 24.12.1990
(51) Int. Cl.: G02B 5/08, G02B 26/10

(54) **Scanning system**
Scanner-Vorrichtung
Dispositif de balayage

(30) Priority: 28.12.1989 JP 344842/89
(43) Date of publication of application: 03.07.1991
(73) Proprietor: CANON KABUSHIKI KAISHA, Tokyo (JP)
(72) Inventor: Iizuka, Takashi, c/o Canon Kabushiki Kaisha, Ohta-ku, Tokyo (JP); Watanabe, Yutaka, c/o Canon Kabushiki Kaisha, Ohta-ku, Tokyo (JP); Fukuda, Yasuaki, c/o Canon Kabushiki Kaisha, Ohta-ku, Tokyo (JP)
(74) Representative: Beresford, Keith Denis Lewis

(56) References cited:
- EP-A- 0 083 394
- EP-A- 0 238 416
- US-A- 4 714 308
- PATENT ABSTRACTS OF JAPAN vol. 9, no. 93 (P-351)(1816) April 23, 1985 & JP-A- 59 220 707

## Description

### FIELD OF THE INVENTION AND RELATED ART

This invention relates generally to a reflection device with a mirror having a multilayered film. In another aspect, the invention relates to a scanning system or an exposure apparatus with such a reflection device.

More particularly, the invention is concerned with a reflection device with a mirror having a multilayered film, effective to reflect light of wavelength 200 nm or less, such as X-rays, vacuum ultraviolet rays or the like, to produce expanded or diffused reflection light. In another aspect, the invention is concerned with a scanning system or an exposure apparatus with such a reflection device.

Conventionally, for reflection of light of wavelength 200 nm or less, having a small divergent angle, such as X-rays or vacuum ultraviolet rays, for example, and for enlarging the diameter of the light, a fixed convex mirror or a swingingly moved convex or flat mirror is used. If, when such a mirror is used, it is desired to provide an increased reflectivity with respect to a particular wavelength, as compared with the other wavelengths, it may be considered that a multilayered film designed with respect to the particular wavelength may be formed on the mirror surface. However, the provision of such a multilayered film on the mirror surface involves such problems as follows.

In a fixed convex mirror, different portions of light inputted to the reflection surface of the mirror impinge on different positions on the convex reflection surface of the mirror. As a result, at these positions, the inputted light rays have different angles (angles of incidence) with respect to the reflection surface. On the other hand, generally a multilayered film is so optimized that it exhibits its performance when light of a predetermined wavelength is inputted thereto with a predetermined angle (angle of incidence). Accordingly, in the case of the fixed convex mirror, there is a possibility that, with regard to the predetermined wavelength, only the reflection light rays produced around the peak of the mirror, for example, have intensified strength (as compared with the other wavelengths), and those reflection light rays produced by the other portions of the mirror have intensified strength in respect to some wavelength other than the predetermined wavelength.

If this occurs, then the reflection light produced by this mirror has spatial non-uniformness in wavelength, in its section.

In a swingable mirror, on the other hand, the inclination of the reflection surface to the light inputted thereto changes with time. As a result, the angle of incidence of the light with respect to the reflection surface also changes with time. This leads to that, in the produced reflection light with which a surface to be illuminated is scanned, such light component as having a relatively strong light intensity has a varying wavelength.

Where such a fixed mirror or a swingable mirror is used in an illumination system of an X-ray exposure apparatus, for example, to expose a semiconductor wafer with X-rays reflected by this mirror, since generally the sensitivity of a resist applied to the wafer has a dependence upon the wavelength, the non-uniformness in wavelength or the variation in wavelength such as described above bars uniform exposure.

### SUMMARY OF THE INVENTION

It is accordingly a primary object of the present invention to provide an improved reflection mirror which is free from the above-described inconveniences.

It is another object of the present invention to provide a reflection device with such a reflection mirror.

It is a further object of the present invention to provide a scanning system with such a reflection device.

It is yet another object of the present invention to provide an exposure apparatus with such a reflection device.

According to a first aspect of the present invention there is provided a scanning system, comprising a radiation source, a reflection mirror for reflecting a radiation beam from said radiation source to produce a reflected beam, and a driving device for swinging said reflection mirror so as to deflect the radiation beam, characterized in that: said driving device is adapted to swing said reflection mirror so that the position and angle of incidence of the radiation beam on said reflection mirror are correspondingly changed; and said reflection mirror has a multi-layered film formed thereon having a thickness gradually increasing with an increasing distance from said radiation source in a plane containing the incident and reflected radiation beams, wherein the thickness of said multi-layered film is such that a change of wavelength spectrum of the reflected beam in dependence upon the position and angle of incidence of the radiation beam is substantially avoided.

According to a second aspect of the present invention there is provided an exposure apparatus comprising a scanning system in accordance with the first aspect of the present invention, and an illumination system for illuminating a mask pattern with a radiation beam deflected by said scanning system, such that a wafer is exposed to the beam after the beam has passed through the mask pattern.

In the present invention, a reflection mirror, having a flat reflection surface, a concave reflection surface or a convex reflection surface may be used.

In one preferred form of the present invention, the mirror has a flat reflection surface and the driving device rotationally moves the reflection mirror through a rotational shaft space from the reflection surface. In another preferred form, the reflection mirror has a convex reflection surface and the driving device rotationally moves the reflection mirror through a rotational shaft spaced from the reflection surface or, alternatively, the driving device oscillatingly moves the reflection mirror in a direction traversing the radiation beam.

Preferably, in the present invention, the reflection mirror is disposed so that the radiation beam such as X-rays is grazingly inputted (at a certain grazing angle) to the reflection surface thereof, so as to ensure enhanced reflectivity.

It is to be noted here that the term "plane of incidence" means a plane that contains the radiation beam inputted to the reflection surface of the reflection mirror and the reflection beam produced by this reflection surface.

These and other objects, features and advantages of the present invention will become more apparent upon a consideration of the following description of the preferred embodiments of the present invention taken in conjunction with the accompanying drawings.

### BRIEF DESCRIPTION OF THE DRAWINGS

Figure 1 is a schematic and diagrammatic view of an exposure apparatus according to an embodiment of the present invention.

Figure 2 is a schematic and diagrammatic view of a scanning system shown in Figure 1.

Figure 3 is a schematic and diagrammatic view of another example of scanning system usable in the exposure apparatus of Figure 1.

Figure 4 is a graph showing wavelength spectrum at opposite ends with respect to a scan direction, where a certain surface is scanned by using a scanning system according to the present invention.

Figure 5 is a graph similar to Figure 4, but the surface is scanned by swinging a mirror with a multilayered film whose layers have uniform thickness throughout the entire reflection surface.

### DESCRIPTION OF THE PREFERRED EMBODIMENTS

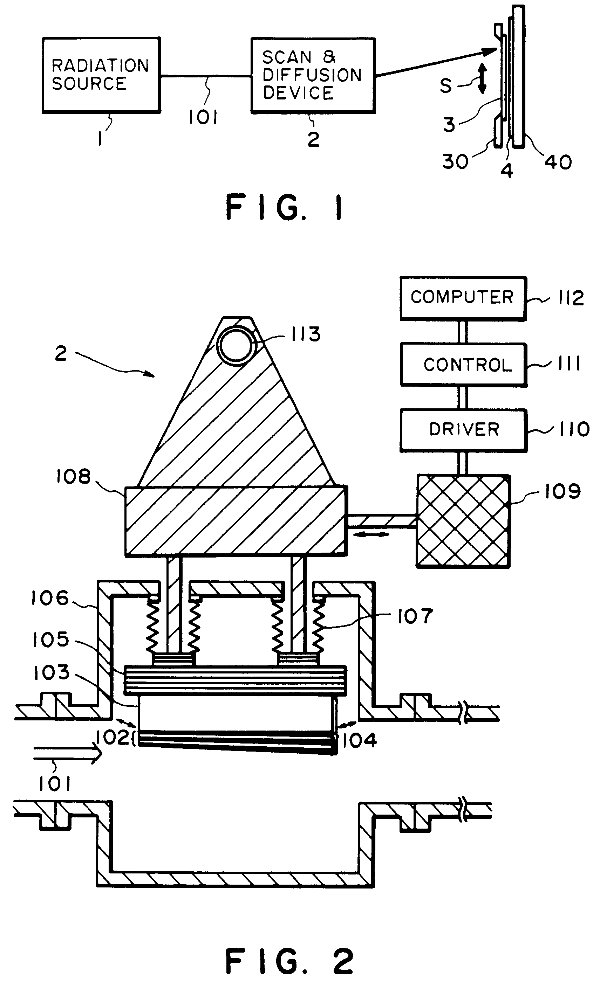

Referring to Figure 1 showing an exposure apparatus according to an embodiment of the present invention, denoted at 1 is a radiation source such as an X-ray source, for example, adapted to produce a radiation beam such as X-rays, for example, which contains different wavelengths and which has a relatively wide bandwidth and a relatively small divergent angle. Denoted at 2 is a scan and diffusion device having a swingable mirror; at 3 is a mask on which a circuit pattern is formed; at 4 is a semiconductor wafer having a resist applied to the surface thereof; at 30 is a mask stage for holding the mask 3; and at 40 is a wafer stage for holding the wafer 4. The radiation source 1, the scan and diffusion device 2 and the stages 30 and 40 are disposed along a horizontal axis.

The scan and diffusion device 2 is arranged to reflect the X-ray beam 101 with its mirror and to scanningly deflect the X-ray beam in a direction or directions as denoted by an arrow S in Figure 1. In this manner, it produces a diffused X-ray beam (reflection beam) with which the mask 3 is illuminated and, thus, the resist of the wafer 4 is exposed to the mask pattern with the X-ray beam. Although not shown in Figure 1, the X-ray beam is propagated within a tube or a chamber the inside of which is evacuated. If desired, the inside of such a tube of a chamber is filled with a He gas, for example.

The swingable mirror of the scan and diffusion device 2 has a substrate and a reflection film formed on the substrate, and the reflection film is provided by a multilayered film. Each layer constituting the multilayered film has a thickness which gradually increased with an increase in the distance from the radiation source 1, in the plane of incidence of the radiation beam (X-ray beam) 101.

In designing such a mirror, first the angle of incidence of the radiation beam such as the X-ray beam 101 to the mirror (reflection surface) is taken into account, and the necessary angle of swinging movement of the mirror is determined in accordance with the size of a required illumination zone. Then, the optimum multilayered structure of the reflection film is determined.

As for the material of the substrate of the reflection mirror, silica (SiO₂) may be the best, particularly in light of the lapping precision and the like. However, any other material may be used. For example, silicon carbide (SiC) or other metal materials may be used.

Typically, the multilayered structure film comprises alternately accumulated different-material layers. As regard the materials, preferably two different materials having a large difference in real part of the complex index of refraction, in respect to the wavelength of X-rays in question, but having small imaginary parts of the complex index of refraction, may be selected. For the method of formation of such a film, high frequency magnetron sputtering method or ion beam sputtering method, for example, is effective. However, any other method such as any one of various sputtering methods, electron beam deposition methods, chemical vapor deposition methods, for example, is usable.

In order to ensure continuous change in the period of the multilayered film (i.e. the thickness of each layer), during the film formation, a method wherein a shutter means is disposed before the substrate and the open time period of the shutter is controlled, can be used. More specifically, a shutter means is disposed before the substrate surface on which the film is to be formed, and the opening of a shutter blade of the shutter means is initiated from that side of the substrate surface at which a larger thickness film is to be formed. The opening movement of the shutter blade is made continuously. By repeating such operation for all the layers to be formed, the resultant multilayered film has a continuously changing period (film layer thickness). However, the film forming method is not limited to this, and any other method may be used.

Figure 2 shows details of an example of scan and diffusion device 2 of the Figure 1 embodiment. In this example, the device 2 has a reflection mirror 104 having a substrate with a flat surface on which a multilayered film is formed. More particularly, the surface of the substrate 103 is finished by lapping and a multilayered film 102 is formed on this surface. In the horizontal direction along the surface of the substrate 103, the multilayered film 102 has a continuously changing period. More specifically, each layer of the multilayered film 102 has a thickness which increases linearly, in a direction from the X-ray beam input side toward the output side. Here, the thickness of each layer at a given point on the substrate 103 surface is determined so that a quantity "d x sinθₓ" is maintained substantially constant, where θₓ is the angle of incidence of the X-ray beam 101 which changes with the angular position of the mirror 104 and d is the thickness at a particular position within the section of the input X-ray beam 101 (for example, at the center of the section of the X-ray beam).

In this example, the mirror swinging mechanism is such as illustrated, and it comprises an actuator 109, a driver 110, a controller 111 and a system control computer 112, wherein the actuator 110 is driven through the system control computer 112, the controller 111 and the driver 110. By this drive, a movable portion 108 of the actuator is swingingly moved along an arcuate, about a rotational shaft 113, whereby the mirror 104 which is held by a base holder 105 and placed within a chamber 106 is swingingly moved along an arcuate, about the shaft 113. Denoted at 107 are bellows for intercepting the inside of the chamber 106 from the driving part (108, 109 and 113) and to sealingly close the chamber 106.

The swinging mechanism is not limited to this, and any one that can swing the mirror 104 is usable. An example is that: a supporting means for supporting the mirror is provided, and a driving means is coupled to the mirror or the supporting means to drive the same. The illustrated example has a computer-control function.

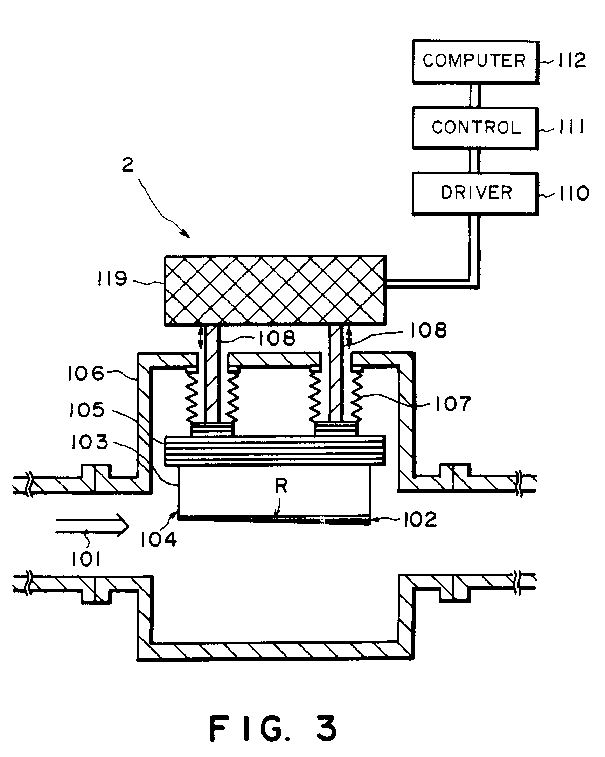

Another form of the scan and diffusion device 2 is illustrated in Figure 3. In Figure 3, like numerals as those of Figure 2 are assigned to similar elements. Denoted at 108 are movable arms, and denoted at 119 is an actuator which operates to move the arms 108 upwardly and downwardly. An end of each arm 108 is coupled to a base 105, such that the base 105 and the mirror 104 are supported by the arms 108.

In this example, the substrate 103 of the mirror 104 has a convex shape quadratically curved surface (cylindrical surface) having a very large curvature radius R, and a multilayered film 102 is formed on this surface. Basically, the film 102 has a similar multilayered structure as that of the mirror 104 of Figure 2, and the thickness of each layer increases with an increase in the distance from the radiation source 1 (Figure 1).

In this example, the mirror 104 is oscillatingly moved upwardly and downwardly so as to traverse the path of the X-ray beam 101, by means of the actuator 119 and the arms 108. As a result, the mirror 104 scans the X-ray beam while reflecting the same. Thus, the mirror 104 produces a diffused reflection beam (X-ray beam).

The scan and diffusion device 2 may be modified in a manner, different from those shown in Figures 2 and 3. As an example, a convex mirror such as shown in Figure 3 may be mounted to the support 105 of Figure 2, such that the mirror may be moved along an arcuate.

A practical example of reflection mirror 104 which may have a flat or convex reflection surface will now be explained.

A silica substrate 103 having its surface finished by lapping to an order of a flatness λ/20 (λ = 6328 Å) and a surface roughness 4.6 Årms and having a size 40 x 40 x 15 (mm) may be used. On such substrate, four layers of ruthenium (Ru) and three layers of aluminium (Al) may be alternately accumulated in accordance with the ion sputtering method, to provide a multilayered film 102 with total seven layers. The thickness of each layer may be continuously changed rectilinearly, in accordance with the aforementioned shutter control method. For the ruthenium layer, it may have a thickness changing from 17.2 Å to 51.4 Å. For the aluminium layer, it may have a thickness changing from 7.8 Å to 78.9 Å. In the shutter control method, a rectangular shutter may be provided before the substrate 103 and may be moved at a constant speed in a horizontal direction along the surface of the substrate.

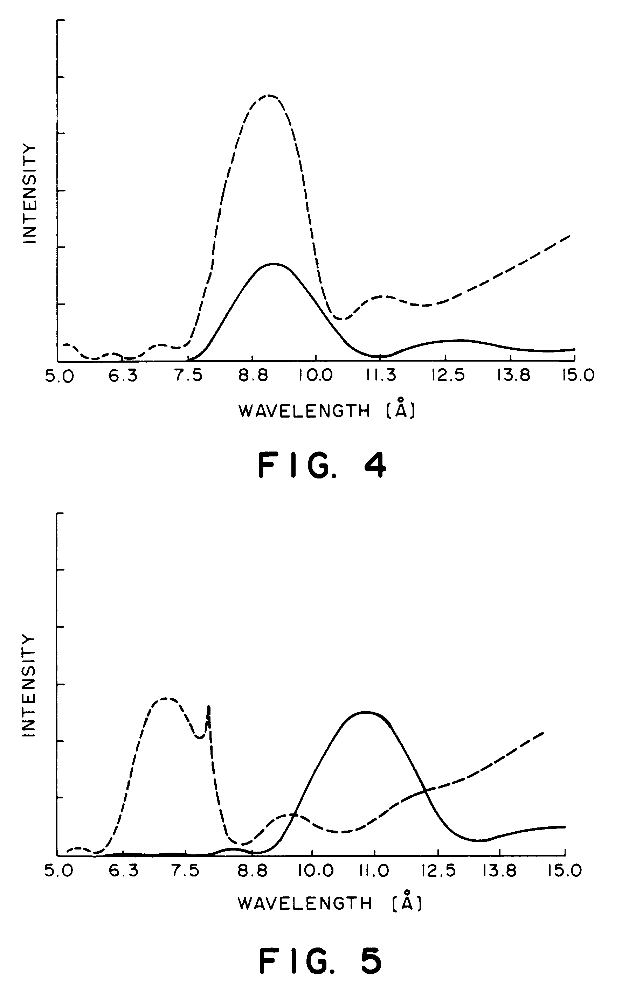

Assuming that such a mirror 104 was disposed in a mirror chamber, simulations were made on the assumption that the mirror was swung along an arcuate with a rotational radius 1 m; a beam of X-rays from a synchrotron orbit radiation (SOR) source was inputted to the mirror; the angle of swinging movement was ± 0.86 deg.; the X-ray beam had an angle of incidence of 4 deg. upon the mirror as the mirror's angular position was zero (0) deg.; and the point of measurement for measuring the produced reflection beam (X-ray beam) was set at a distance 1 m from the mirror 104. From the results, it has been confirmed that the input X-ray beam having a vertical expansion of 5 mm just before the mirror 104 can be expanded and projected to illuminate an illumination zone of 30 mm. Also, it has been confirmed that the center wavelength of the projected X-ray beam can be maintained substantially at 9 Å, at each of the upper edge, the center and the lower edge of the illumination zone, and that throughout the zone the variation of wavelength can be suppressed sufficiently. Figure 4 illustrates an exemplary wavelength distribution at the upper edge (solid line) and that at the lower edge (broken line) of the illumination zone.

As a comparative example, similar simulations were made on the assumption that a multilayered film having an optimized design with respect to light of 9 Å was formed on a substrate with uniform layer thickness; the substrate was made of silica; each ruthenium layer had a uniform thickness of 33.8 Å throughout the substrate surface; each aluminium layer had a uniform thickness of 38.9 Å throughout the substrate surface; and the total number of the layers and the angle of swinging movement of the mirror as well as the angle of incidence of the input X-ray beam were the same as those of the simulations made with regard to the mirror of the present invention. From the results, it has been confirmed that, although a similar illumination zone of 30 mm can be obtained at a distance 1 m from the mirror, the center wavelength of the X-ray beam is 11 Å at the upper edge of the zone and 7 Å at the lower edge of the zone, and that there is produced non-uniformness of wavelength of about 4 Å throughout the illumination zone. Figure 5 shows an exemplary wavelength distribution at the upper edge (solid line) and that at the lower edge (broken line) where such a multilayered film with uniform layer thickness is used.

Another practical example of reflection mirror of the present invention will now be explained.

A silica substrate 103 having a cylindrical surface finished by lapping to an order of surface precision λ/10 and surface roughness 5.0 Årms and having a size 350 x 80 x 50 (mm) and a radius R = 50 m, may be used. On this cylindrical surface, eight layers of ruthenium (Ru) and seven layers of aluminium (Al) may be accumulated alternately in accordance with the high frequency magnetron sputtering method, to provide a multilayered film 102 with total fifteen layers. The thickness of each layer may be changed continuously from an end to the other end, in accordance with the shutter control method described hereinbefore. Within a range of ± 35 mm about the center (peak) of the substrate 103 and along an arcuate (cylindrical surface), each ruthenium layer may have a thickness changing from 15.0 Å to 35.5 Å (from an end to the other end), while each aluminium layer may have a thickness changing from 9.5 Å to 106.5 Å.

Assuming that such a convex mirror 104 was disposed in a mirror chamber, simulations were made on the assumption that the mirror was swung along an arcuate with a rotational radius 1 m; a beam of X-rays from a synchrotron orbit radiation (SOR) source was inputted to the mirror; the angle of swinging movement was ± 0.86 deg.; the X-ray beam had an angle of incidence of 5 deg. upon center (peak) of the mirror as the mirror's angular position was zero (0) deg.; and the point of measurement for measuring the produced reflection beam (X-ray beam) was set at a distance 1 m from the mirror 104. From the results, it has been confirmed that the input X-ray beam having a vertical expansion of 5 mm just before the mirror 104 can be expanded and projected to illuminate an illumination zone of 93 mm. Also, it has been confirmed that the center wavelength of the projected X-ray beam can be maintained substantially at 10 Å, at each of the upper and lower edges of the illumination zone, and that throughout the zone the variation of wavelength can be suppressed sufficiently.

It will be understood from the foregoing description that the reflection mirror of the present invention has an advantage that the produced reflection beam has small non-uniformness of wavelength, in addition to the advantage of transforming light of a small divergent angle into light of sufficient expansion to illuminate a wide zone.

When such a mirror is used in an X-ray exposure apparatus, for example, it is possible to avoid or reduce the correction of non-uniform exposure dependent upon the spectral sensitivity of a used resist and, therefore, there is no necessity of complicated workings of correction based on characteristics of individual resist materials. Also, when such a mirror is used, uniform exposure of a resist on a wafer is easily attainable even in a case where the illuminance in the exposure region is not uniform, by setting different the exposure time periods to different portions of the exposure region in accordance with the non-uniformness in illuminance. For this exposure control, a known method such as discussed in a paper "Summary of Society of Japanese Applied Physics, 1988, Spring, 31a-k-9", by Nihon Denki Kabushiki Kaisha, may be used. Wile in that occasion it is necessary to measure the strength of the illumination light by some means, the strength of the illumination light should correspond to the absorption characteristics (wavelength dependence) of the used resist.

On the other hand, recently, attention has been paid to the damage by radiation of a radiation optical element. Since in the arrangement shown in Figure 1, 2 or 3 the mirror 104 is swingingly or oscillatingly moved, the position of incidence of the radiation upon the mirror changes with time. Therefore, the possibility of local damage of the mirror surface is very small. Further, by appropriately selecting the shape of the mirror reflection surface or the angle of swinging movement, for example, it is easily possible to adjust the distance or the angle of view and, by appropriately selecting the materials, the number of layers, the layer thickness or the layer thickness distribution, for example, of the multilayered film, it is easily possible to obtain a desired wavelength distribution.

In another aspect, the present invention is applicable to a reflection mirror which is to be fixedly secured. Where such a mirror is to be used in an exposure apparatus, preferably it may have a convex reflection surface. A multilayered film may be formed on the convex reflection surface, each layer having a thickness changing with position on the reflection surface. This is effective to suppress non-uniformness in wavelength of a produced reflection beam from the reflection surface, resulting from different angles of incidence of different portions of an input radiation beam, impinging upon different positions of the reflection surface of the mirror. Accordingly, it is easily possible to obtain a reflection beam having sufficient expansion and sufficiently reduced non-uniformness in wavelength.

The radiation beam to be used in the present invention is not limited to X-rays or vacuum ultraviolet rays. For the reflection of ultraviolet rays, visible rays or infrared rays of a wavelength 200 nm or larger, for example, the present invention can be used. The present invention is particularly effective, where it is used with a radiation beam having a relatively wide bandwidth.

While the invention has been described with reference to the structures disclosed herein, it is not confined to the details set forth and this application is intended to cover such modifications or changes as may come within the purposes of the improvements or the scope of the following claims.

## Claims

1. A scanning system, comprising a radiation source (1), a reflection mirror (104) for reflecting a radiation beam (101) from said radiation source (1) to produce a reflected beam, and a driving device (2) for swinging said reflection mirror (1) so as to deflect the radiation beam, characterized in that:
said driving device (2) is adapted to swing said reflection mirror (104) so that the position and angle of incidence of the radiation beam on said reflection mirror (104) are correspondingly changed; and
said reflection mirror (104) has a multi-layered film (102) formed thereon having a thickness gradually increasing with an increasing distance from said radiation source in a plane containing the incident and reflected radiation beams (101), wherein the thickness of said multi-layered film (102) is such that a change of wavelength spectrum of the reflected beam in dependence upon the position and angle of incidence of the radiation beam (101) is substantially avoided.

2. A scanning system according to Claim 1, wherein said reflection mirror (104) is disposed so that the radiation beam (101) from said radiation source (1) is grazingly incident on said reflection mirror (104).

3. A scanning system according to Claim 1 or 2, wherein said reflection mirror (104) has a flat reflection surface and wherein said driving device (2) rotationally moves said reflection mirror (104) about a rotational shaft (113) spaced from said reflection surface.

4. A scanning system according to Claim 1 or 2, wherein said reflection mirror (104) has a convex reflection surface and wherein said driving device (2) rotationally moves said reflection mirror (104) about a rotational shaft (113) spaced from said reflection surface.

5. A scanning system according to Claim 1 or 2, wherein said reflection mirror has a convex reflection surface and wherein said driving device (2) oscillatingly moves said reflection mirror (104) rectilinearly in a direction traversing the radiation beam (101).

6. A system according to any one of the preceding claims, wherein said radiation source (1) comprises an X-ray source.

7. An exposure apparatus, comprising:
a scanning system as recited in any one of the preceding claims; and
an illumination system for illuminating a mask pattern (3) with a radiation beam (101) deflected by said scanning system, such that a wafer (4) is exposed to the beam (101) after the beam (101) has passed through the mask pattern (3).

## Patentansprüche

1. Abtastsystem mit einer Stahlungsquelle (1), einem Reflexionsspiegel (104) zum Reflektieren eines Strahlungsstrahls (101) von der Strahlungsquelle (1), um einen reflektierten Strahl zu erzeugen, und einer Antriebsvorrichtung (2) zum Schwingen des Reflexionsspiegels (1), um den Strahlungsstrahl abzulenken, dadurch gekennzeichnet, daß:
die Antriebsvorrichtung dazu ausgelegt ist, den Reflexionsspiegel (104) derart zu schwingen, daß die Position und der Einfallswinkel des Strahlungsstrahls auf dem Reflexionsspiegel (104) entsprechend verändert werden, und
der Reflexionsspiegel (104) eine darauf ausgebildete mehrlagige Beschichtung (102) aufweist, welche eine Dicke hat, die mit zunehmendem Abstand von der Strahlungsquelle in einer den einfallenden und den reflektierten Strahlungsstrahl (101) enthaltenden Ebene allmählich zunimmt, wobei die Dicke der mehrlagigen Beschichtung (102) so ist, daß eine Veränderung des Wellenlängenspektrums des reflektierten Strahls in Abhängigkeit von der Position und dem Einfallswinkel des Strahlungsstrahls (101) im wesentlichen verhindert wird.

2. Abtastsystem nach Anspruch 1, wobei der Reflexionsspiegel (104) derart angeordnet ist, daß der Strahlungsstrahl (101) von der Strahlungsquelle (1) streifend auf den Reflexionsspiegel (104) auftrifft.

3. Abtastsystem nach Anspruch 1 oder 2, wobei der Reflexionsspiegel (104) eine ebene Reflexionsoberfläche aufweist, und wobei die Antriebsvorrichtung (2) den Reflexionsspiegel (104) rotierend um eine Rotationsachse (113), die von der Reflexionsoberfläche beabstandet ist, bewegt.

4. Abtastsystem nach Anspruch 1 oder 2, wobei der Reflexionsspiegel (104) eine konvexe Reflexionsoberfläche aufweist, und wobei die Antriebsvorrichtung (2) den Reflexionsspiegel (104) rotierend um eine Rotationsachse (113), die von der Reflexionsoberfläche beabstandet ist, bewegt.

5. Abtastsystem nach Anspruch 1 oder 2, wobei der Reflexionsspiegel eine konvexe Reflexionsoberfläche aufweist, und wobei die Antriebsvorrichtung (2) den Reflexionsspiegel (104) oszillierend geradlinig in eine den Strahlungsstrahl (101) kreuzende Richtung bewegt.

6. System nach einem der vorhergehenden Ansprüche, wobei die Strahlungsquelle (1) eine Röntgenstrahlquelle aufweist.

7. Belichtungsgerät mit
einem wie in einem der vorhergehenden Ansprüche dargestellten Abtastsystem, und
einem Beleuchtungssystem zum Beleuchten eines Maskenmusters (3) mit einem Strahlungsstrahl (101), der durch das Abtastsystem derart abgelenkt wird, daß ein Wafer (4) dem Strahl (101) ausgesetzt ist, nachdem der Strahl (101) durch das Maskenmuster (3) hindurchgetreten ist.

## Revendications

1. Système de balayage, comportant une source (1) de rayonnement, un miroir réfléchissant (104) destiné à réfléchir un faisceau (101) de rayonnement provenant de ladite source (1) de rayonnement pour produire un faisceau réfléchi, et un dispositif (2) d'entraînement destiné à faire pivoter ledit miroir réfléchissant (1) afin de dévier le faisceau de rayonnement, caractérisé en ce que :
ledit dispositif (2) d'entraînement est conçu pour faire pivoter ledit miroir réfléchissant (104) afin que la position et l'angle d'incidence du faisceau de rayonnement sur ledit miroir réfléchissant (104) soient modifiés de façon correspondante ; et
un film multicouche (102) est formé sur ledit miroir réfléchissant (104) et présente une épaisseur augmentant progressivement avec une distance croissante à partir de ladite source de rayonnement dans un plan contenant les faisceaux de rayonnement incident et réfléchi (101), l'épaisseur dudit film multicouche (102) étant telle qu'une variation du spectre de longueurs d'ondes du faisceau réfléchi en fonction de la position et de l'angle d'incidence du faisceau (101) de rayonnement soit sensiblement évitée.

2. Système de balayage selon la revendication 1, dans lequel ledit miroir réfléchissant (104) est disposé de façon que le faisceau de rayonnement (101) provenant de ladite source de rayonnement (1) arrive en incidence rasante sur ledit miroir réfléchissant (104).

3. Système de balayage selon la revendication 1 ou 2, dans lequel ledit miroir réfléchissant (104) présente une surface réfléchissante plate et dans lequel ledit dispositif d'entraînement (2) déplace en rotation ledit miroir réfléchissant (104) autour d'un axe (113) de rotation espacé de ladite surface réfléchissante.

4. Système de balayage selon la revendication 1 ou 2, dans lequel ledit miroir réfléchissant (104) présente une surface réfléchissante convexe, et dans lequel ledit dispositif d'entraînement (2) déplace en rotation ledit miroir réfléchissant (104) autour d'un axe (113) de rotation espacé de ladite surface réfléchissante.

5. Système de balayage selon la revendication 1 ou 2, dans lequel ledit miroir réfléchissant présente une surface réfléchissante convexe et dans lequel ledit dispositif d'entraînement (2) fait osciller ledit miroir réfléchissant (104) en ligne droite dans une direction transversale au faisceau (101) de rayonnement.

6. Système selon l'une quelconque des revendications précédentes, dans lequel ladite source (1) de rayonnement comprend une source de rayons X.

7. Appareil d'exposition, comportant :
un système de balayage selon l'une quelconque des revendications précédentes ; et
un système d'illumination destiné à illuminer un motif (3) de masque avec un faisceau de rayonnement (101) dévié par ledit système de balayage, de manière qu'une tranche (4) soit exposée au faisceau (101) après que le faisceau (101) a traversé le motif (3) du masque.
